# EUROPÄISCHE PATENTSCHRIFT

(11) **EP 1 200 224 B1**
(45) Veröffentlichungstag und Bekanntmachung des Hinweises auf die Patenterteilung: **24.11.2004**
(21) Anmeldenummer: 00949275.2
(22) Anmeldetag: 06.07.2000
(51) Int. Cl.: B23K 3/06

(54) **DRUCKKOPF ZUM AUSSPRITZEN EINES HEISSEN FLÜSSIGEN MEDIUMS**
PRINTHEAD FOR JETTING A HOT LIQUID MEDIUM
TETE D'IMPRESSION POUR LA PROJECTION D'UN MILIEU LIQUIDE TRES CHAUD

(30) Priorität: 06.07.1999 DE 19931110
(43) Veröffentlichungstag der Anmeldung: 02.05.2002
(73) Patentinhaber: Ekra Eduard Kraft GmbH, 74355 Bönnigheim (DE)
(72) Erfinder: WEHL, Wolfgang, D-74080 Heilbronn (DE); WILD, Jörg, D-74081 Heilbronn (DE)
(74) Vertreter: Grosse, Rainer, Dipl.-Ing.
(86) Internationale Anmeldenummer: PCT/EP2000/006407
(87) Internationale Veröffentlichungsnummer: WO 2001/002123

(56) Entgegenhaltungen:
- EP-A- 0 637 057
- US-A- 5 691 593
- US-A- 5 772 106
- US-A- 5 810 988
- US-A- 5 876 615

## Beschreibung

Die Erfindung betrifft einen Druckkopf zum Ausspritzen eines heißen flüssigen Mediums gemäß Oberbegriff des Anspruchs 1. Die Erfindung betrifft ferner die Verwendung eines nach dem Tintendruckprinzip arbeitenden Druckkopfes.

Aus dem Stand der Technik ist ein sogenannter Piezolamellen-Druckkopf bekannt, der in einem Tintendrucker eingesetzt ist (Chip 8/94; Seite 104-112; "Nur nicht kleckern"). Der Druckkopf besitzt eine Mediumkammer für die flüssige Tinte. Eine Wandung der Mediumkammer ist als auslenkbare Membran ausgebildet, die von einem Aktor betätigt wird. Dieser ist in dem bekannten Druckkopf als Piezoelement ausgebildet, das streifenförmig beziehungsweise als Lamelle realisiert ist. Durch Anlegen einer elektrischen Spannung ändert das Piezoelement seine räumliche Gestalt, wodurch die Membran ausgelenkt wird. Durch diese Auslenkung der Membran wird das Volumen der Mediumkammer verringert, wodurch ein Tropfen der Tinte aus einer Düse beziehungsweise Austrittsöffnung ausgespritzt wird. Bei dem bekannten Druckkopf liegt die Tinte zunächst als fester Wachsstift vor, der vor dem Drucken erwärmt wird, wodurch der Wachsstift dünnflüssig wird, so daß die Flüssigwachstinte in die Mediumkammer eingebracht werden kann, aus der sie dann verspritzt wird. Um das Tintenwachs zu verflüssigen, wird es auf zirka 100 bis 150°C erwärmt. Das Anwendungsgebiet dieses bekannten Druckkopfes ist auf den Tintendruck beschränkt, bei dem die flüssige Tinte auf ein Papier oder eine Folie aufgebracht wird. Insbesondere ein Ausspritzen von sehr heißen flüssigen Medien, deren Temperatur über 150°C liegen kann, ist mit dem bekannten Druckkopf nicht möglich.

Aus der US 5,772,106 ist ein Druckkopf zum Ausspritzen von flüssigen Metallen bekannt. Nachteilig ist dabei, dass der Aktor im Betrieb Temperaturschwankungen unterworfen ist und dabei seine physikalischen Eigenschaften ändert. Zudem ist der vorgeschlagene Druckkopf aufwendig in der Herstellung. Die US 5,810,988 zeigt einen Druckkopf mit einem Piezoelement und einer Membran auf, die thermisch entkoppelt sind. Nachteilig ist jedoch der aufwendige Aufbau des Druckkopfs. Zu Druckköpfen zum Ausspritzen von Metallen sind zwar weitere Schriften bekannt, zum Beispiel US 5,266,098, US 5,229,016, US 3,683,212, US 4,527,717 oder US 4,828,886, doch lassen sich in diesen Vorrichtungen nur Metalle beziehungsweise Metallegierungen mit einem niedrigen Schmelzpunkt verarbeiten.

Es ist daher Aufgabe der Erfindung, den thermischen Einsatzbereich von Druckköpfen zu erweitern und einen Druckkopf aufzuzeigen, der dies bei einfacher Bauweise ermöglicht.

Diese Aufgabe wird mit einem Druckkopf gelöst, der die Merkmale des Anspruchs 1 zeigt. Der erfindungsgemäße Druckkopf dient zum Ausspritzen eines heißen flüssigen Mediums. Er weist eine Mediumkammer auf, deren eine Wandung von einer Membran gebildet ist. Die Membran steht mit einem Aktor in mechanischem Kontakt, so daß die Membran ausgelenkt beziehungsweise angetrieben werden kann. Der Aktor ist von der Membran thermisch entkoppelt, das heißt, daß der Aktor von der Membran wärme- beziehungsweise kältetechnisch isoliert ist. Dadurch wird es möglich, in der Mediumkammer das heiße flüssige Medium auf eine Temperatur zu erwärmen, die notwendig ist, um ein Metall oder eine Metallegierung, insbesondere metallisches Lot, so zu erhitzen, daß es in der Mediumkammer flüssig vorliegt. Mit dem Druckkopf kann diese heiße flüssige metallische Legierung ausgespritzt werden, um sogenannte Lotdepots auf Substraten und/oder Bauelementen aufzubringen. Dadurch, daß der Aktor von der Membran thermisch entkoppelt ist, kann er auf einer Arbeitstemperatur gehalten werden, bei der sich seine physikalischen Eigenschaften im wesentlichen nicht ändern. Das heißt, daß -obwohl in der Mediumkammer sehr heißes flüssiges Metall vorliegen kann- die Membran durch den Aktor sehr genau und präzise angesteuert beziehungsweise ausgelenkt werden kann, so daß ein präzises Ausspritzen von sehr heißen flüssigen Medien aller Art, insbesondere hocherhitzter flüssiger Metalle, mit genau definierter Tropfengröße beziehungsweise -volumen möglich ist.

Die thermische Entkopplung wird von einem Wärmesperrelement vorgenommen, welches zwischen Membran und Aktor liegt. Dieses Wärmesperrelement ist schlecht wärmeleitend, wodurch die an der Membran vorliegende Wärme im wesentlichen nicht zum Aktor weitergeleitet wird. Das Wärmesperrelement ist also ein Element, welches den Wärmetransport von der Membran zum Aktor unterbricht, zumindest jedoch sehr stark vermindert.

Der Aktor ist ein Piezoelement, mit dem es möglich ist, die Membran sehr genau anzusteuern, das heißt auszulenken, so daß ein definiertes Tropfenvolumen aus der Mediumkammer ausgebracht werden kann. Dadurch, daß der Aktor, also das Piezoelement, von der Membran thermisch entkoppelt ist, wird verhindert, daß das Piezoelement auf eine Temperatur gebracht wird, die oberhalb der sogenannten piezoelektrischen Curie-Temperatur liegt. Oberhalb dieser Temperatur ist die Gitterstruktur piezoelektrischer Verbindungen kubisch. Unterhalb dieser Temperatur verzerrt sich die Struktur, wodurch sich Abstände zwischen den positiven und negativen Ladungen verschieben, so daß ein elektrisches Dipolmoment entsteht. Mit anderen Worten: piezoelektrische Verbindungen zeigen ihren piezoelektrischen Effekt nur dann, wenn die Gitterstruktur verzerrt ist, so daß eine spontane Polarisation auftritt. Oberhalb der piezoelektrischen Curie-Temperatur, wenn die Gitterstruktur kubisch ist, tritt bei diesen piezoelektrischen Verbindungen die Piezoelektrizität nicht auf, weil kein elektrisches Dipolmoment vorliegt. Da der erfindungsgemäße Druckkopf mit einem thermisch entkoppelten Piezoelement ausgestattet ist, kann also das heiße flüssige Medium in der Mediumkammer mit einer Temperatur vorliegen, die oberhalb der piezoelektrischen Curie-Temperatur des Piezowerkstoffes liegt, das Piezoelement dadurch jedoch in seiner Funktion nicht beeinträchtigt wird. Bevorzugt wird die thermische Entkopplung so ausgelegt, daß das Piezoelement maximal auf 30 bis 50% der Curie-Temperatur seines Piezowerkstoffes erwärmt wird, da bereits bei höheren Temperaturen eine schleichende Depolarisation auftreten kann.

Das Piezoelement weist einen aktiven und einen das Wärmesperrelement bildenden passiven Bereich aufweist, wobei der aktive Bereich Elektroden zur Ansteuerung des Piezoelements aufweist und der passive Bereich elektrodenlos ausgebildet ist oder die Elektroden im passiven Bereich zwar vorliegen, diese jedoch nicht mit den Elektroden des aktiven Bereichs in elektrisch leitender Verbindung stehen. Da der passive Bereich des Piezoelements für die Ansteuerung beziehungsweise Auslenkung der Membran nicht wirksam ist, hat eine Temperaturerhöhung des passiven Bereichs keinen Einfluß auf die Funktionsweise des aktiven Bereichs. Die Länge des passiven Bereichs wird dabei so bemessen, daß -ausgehend von dem mit der Membran in mechanischen Kontakt stehenden Ende des Aktors- ein Temperaturgefälle in Richtung zum aktiven Bereich derart auftritt, daß die Temperatur am Übergang zwischen passivem und aktivem Bereich weit unterhalb der piezoelektrischen Curie-Temperatur des verwendeten Piezowerkstoffes liegt.

Das Wärmesperrelement ist zudem als einstückiger Bestandteil des Piezoelements ausgeführt. Für das Wärmesperrelement muß also kein separates Bauteil verwendet werden. Der Aktor für die Membran.kann also leicht und kostengünstig hergestellt werden.

Mit dem erfindungsgemäßen, nach dem Tintendruckprinzip arbeitenden Druckkopf ist es also möglich, Lotdepots, die auch als Bumps bezeichnet werden, auf Bauelementen oder Substraten der Mikroelektronik und/oder der Mikromechanik beziehungsweise Mikrosystemtechnik aufzubringen. Lotdepots werden beispielsweise beim sogenannten Tape-Automated-Bonding (TAB), beim Chip-Size-Packaging (CSP) und auch bei der sogenannten Flip-Chip-Verbindung (FC) als Verbindungselemente zwischen Bauteilen und Substrat benötigt. Die Lotdepots liegen in den meisten Fällen in höckerförmiger Gestalt vor, wobei als Lot insbesondere eutektische Zinn-Blei- oder Zinn-Gold-Legierungen verwendet werden. Mit dem erfindungsgemäßen Druckkopf können diese Lotdepots nunmehr schnell, präzise und kostengünstig auf die Bauelemente beziehungsweise Substrate aufgebracht werden, um die für die oben erwähnten Verbindungstechniken notwendigen Lotdepots zu erzeugen.

Nach einer Weiterbildung der Erfindung ist vorgesehen, daß der Querschnitt im Bereich des Wärmesperrelements kleiner als der übrige Bereich des Aktors ist. Somit liegt zwischen Membran und Wärmesperrelement eine geringe Kontaktfläche vor, die den Wärmeübergang vermindert. Alternativ oder zusätzlich kann vorgesehen sein, daß sich das Wärmesperrelement in Richtung zum membranseitigen Ende hin verjüngt.

In bevorzugter Ausführungsform sind die übrigen Wandungen der Mediumkammer von einem Silizium umfassenden Substrat gebildet. Es kann vorgesehen sein, daß das Substrat wannenartig ausgebildet ist, wobei an der Innenseite des Substrat mikromechanische Strukturen vorliegen können, die eine Mediumführung innerhalb der Mediumkammer bilden. Außerdem können die mikromechanischen Strukturen eine Ausspritzöffnung für das heiße flüssige Medium bilden. Die Öffnung des wannenartigen Substrats wird somit von der Membran abgedeckt. Bevorzugt wird eine Membran aus Borosilikatglas oder aus Silizium verwendet. Vorzugsweise wird die Membran auf dem die Öffnung der Wanne umgebenden Rand des Substrats befestigt. Liegt die Membran als Borosilikatglas vor, wird sie vorzugsweise durch anodisches Bonden an dem Substrat befestigt. Liegt die Membran als Siliziummembran vor, wird diese vorzugsweise durch das sogenannte Silicon-Fusion-Bonding am Substrat befestigt. Allgemein gilt, daß der Werkstoff für die Membran derart wärmefest ist, daß das in der Mediumkammer vorliegende heiße Medium die Membran nicht beschädigt.

Nach einem Ausführungsbeispiel ist vorgesehen, daß der Aktor von einem Gehäuse umgeben ist. Der Aktor ist also von äußeren Einflüssen abgeschirmt.

In bevorzugter Ausführungsform ist der Aktor als Lamelle ausgebildet. Er liegt also als langer dünner Streifen vor, dessen Querschnitt wesentlich geringer als seine Länge ist. Der Aktor beziehungsweise die Lamelle erstreckt sich zwischen der Membran und einer ein Widerlager für den Aktor bildenden Gehäusewand. Mit seinem einen Ende stützt sich der Aktor also an der Membran ab und mit seinem anderen Ende wird er in der Gehäusewandung gehalten, so daß eine Kraftübertragung vom Aktor auf die Membran erfolgen kann. Bei der elektrischen Ansteuerung des Aktors dehnt er sich aus und zieht sich zusammen, wodurch sich seine Länge ändert. Diese, Längenänderung bewirkt somit die Auslenkung der Membran, da sein der Membran abgewandtes Ende an der Gehäusewandung festgelegt ist. Vorzugsweise ist vorgesehen, daß die Gehäusewand eine Ausnehmung aufweist, in die der Aktor mit seinem der Membran abgewandten Ende eingreift. Bevorzugt ist hierbei vorgesehen, daß sich der Aktor durch diese Ausnehmung hindurch erstreckt, so daß an seinem freien Ende, welches außerhalb des Gehäuses liegt, ein Kontaktierungselement für die Elektroden angeordnet sein kann. Somit kann der Aktor außerhalb des Gehäuses mit einer elektrischen Ansteuerung.verbunden werden, wobei zur Kontaktierung beziehungsweise elektrisch leitenden Verbindung eine flexible oder starre Leiterplatte vorgesehen ist, die auf das Kontaktierelement des Aktors aufgesteckt werden kann und ein entsprechendes Gegenkontaktierelement besitzt.

Das Gehäuse für den Aktor bildet einerseits eine Schutzbarriere für den Aktor und dient andererseits als Tragkörper für den Aktor, der mit seinem einen Ende an dem Gehäuse, also an dem Tragkörper befestigt ist.

Besonders bevorzugt wird ein Ausführungsbeispiel, bei dem das Gehäuse, also der Tragkörper, elektrisch isolierend und/oder schlecht wärmeleitend ausgebildet ist. Hierzu kann vorgesehen sein, daß der Tragkörper aus Keramik, vorzugsweise Zirkonoxid, besteht.

In bevorzugter Ausführungsform ist vorgesehen, daß die Membran der Mediumkammer eine Wand des Gehäuses für den Aktor bildet. Mit anderen Worten: der Tragkörper beziehungsweise das Gehäuse ist an der Mediumkammer angebracht, und zwar derart, daß eine Öffnung des Gehäuses von der Membran abgedeckt ist. Das Gehäuse ist also einseitig offen ausgebildet und wird erst bei seiner Montage an der Mediumkammer von der Membran verschlossen. Für die Verbindung zwischen Mediumkammer und Gehäuse ist. eine thermische Entkopplung zwischen beiden Bauteilen vorgesehen, so daß die an der Membran vorliegende Wärme nicht über das Gehäuse zum Aktor vordringen kann. Die thermische Entkopplung zwischen Mediumkammer beziehungsweise Membran und dem Gehäuse wird bevorzugt durch Reduzierung der Kontaktfläche zwischen den Rändern des Gehäuses und der Membran gebildet. Beispielsweise kann hier zumindest ein Schlitz in der Gehäusewandung eingebracht sein, der vorzugsweise randoffen ausgebildet ist. Werden mehrere Schlitze in das Gehäuse eingebracht, liegt vorzugsweise eine kammartige Struktur vor. Durch den/die Schlitz(e) wird die Kontaktfläche zwischen Gehäuse und Membran verringert, wodurch ein geringer Wärmeübergang von der Membran beziehungsweise Mediumkammer zu dem Gehäuse vorliegt. Die in dem Gehäuse vorgesehenen Schlitze bilden in besonders vorteilhafter Weise auch eine Wärmeausdehnungskompensation. Das heißt, bei einer Erwärmung des Gehäuses verzieht sich dieses nicht, wodurch der Aktor bezüglich seiner Lage zur Membran stabil und positionsgenau gehalten ist.

Für die Verbindung zwischen Membran und Gehäuse ist vorzugsweise vorgesehen, die Seite der Membran, die dem Gehäuse zugewandt liegt, zumindest bereichsweise durch Bedampfen und Sputtern zu vergolden. Bevorzugt ist dann der Tragkörper an seiner mit der Membran vorgesehenen Verbindungsstelle mit einer goldhaltigen Dickschicht-Einbrennpaste vergoldet ausgebildet, so daß die Verbindung zwischen Membran und Tragkörper durch eine Goldschweiß- oder Lötverbindung einfach hergestellt werden kann.

Bei einem Ausführungsbeispiel ist vorgesehen, daß der Druckkopf eine Heizeinrichtung für das Medium aufweist. Alternativ oder zusätzlich kann vorgesehen sein, daß das Medium bereits heiß und.flüssig dem Druckkopf zugeführt wird. Die Heizeinrichtung ist bevorzugt als Lichtquelle ausgebildet, wobei die Lichtquelle vorzugsweise eine Halogenlampe ist. Alternativ oder zusätzlich kann die Heizeinrichtung durch Heizwiderstände gebildet sein. Diese Heizwiderstände können an dem die Mediumkammer bildenden Substrat angebracht sein. Bevorzugt werden die Heizwiderstände in Dünnschicht-Technik auf das Substrat aufgebracht, wobei die Heizwiderstände vorzugsweise Hafniumdiborid umfassen. Die Heizwiderstände können durch Sputtern auf das Substrat aufgebracht und durch litographisches Strukturieren geformt werden. Alternativ oder zusätzlich zur Heizeinrichtung kann eine Kühleinrichtung vorgesehen sein, die insbesondere das Substrat, also Teile der Mediumkammer kühlt. Bevorzugt wird die Kühleinrichtung durch eine sogenannte Wärmesenke gebildet, die vorzugsweise als Peltierelement ausgebildet ist.

Die Heizeinrichtung und/oder Kühleinrichtung ist in bevorzugter Ausführungsform der Mediumkammer zugeordnet, so daß mittels der Heizeinrichtung das in der Mediumkammer vorliegende Medium erwärmt und so flüssig gehalten werden kann. Die Kühleinrichtung kann dabei -sofern dies notwendig sein sollte- das Substrat, also Teile der Mediumkammer kühlen.

Nach einem bevorzugten Ausführungsbeispiel ist die Heiz- und/oder Kühleinrichtung von einer Einhäusung umgeben, die vorzugsweise an der der Membran gegenüberliegenden Wandung der Mediumkammer befestigt ist. Diese Wandung der Mediumkammer bildet in bevorzugter Ausführungsform eine Wandung der Einhäusung für die Heiz- und/oder Kühleinrichtung. Die Einhäusung ist vorzugsweise innen verspiegelt ausgebildet und besteht in bevorzugter Ausführungsform aus Metall und/oder einer Keramik.

Nach einer Weiterbildung der Erfindung ist vorgesehen, daß die Einhäusung von dem Substrat, also von der Mediumkammer, thermisch entkoppelt ist. Alternativ oder zusätzlich kann die Einhäusung thermisch schlecht leitend ausgebildet sein. Für die thermische Entkopplung kann zwischen der Einhäusung und dem Substrat eine schlecht wärmeleitende Schicht vorgesehen sein.

Bei einem Ausführungsbeispiel ist vorgesehen, daß die Mediumkammer mindestens eine, insbesondere mehrere Ausspritzöffnungen für das heiße flüssige Medium besitzt. Vorzugsweise ist jeder Ausspritzöffnung jeweils ein Aktor zugeordnet. Vorzugsweise ist auch vorgesehen, daß die Mediumkammer als einzelne voneinander getrennte Teilmediumkammern vorliegt, wobei jede Teilmediumkammer zumindest eine Ausspritzöffnung besitzt. Somit sind die Ausspritzöffnungen beziehungsweise die jeder Ausspritzöffnung zugeordnete Teilmediumkammer über den entsprechenden Aktor unabhängig voneinander aktivierbar.

Ein besonders bevorzugtes Ausführungsbeispiel zeichnet sich durch eine Schutzmediumaustrittsöffnung aus, die vorzugsweise so gerichtet ist, daß ein Schutzmedium in Richtung der Ausspritzöffnung beziehungsweise der Ausspritzöffnungen austritt. Das Schutzmedium verhindert die Oxidation des heißen flüssigen Mediums, wenn dieses aus der Ausspritzöffnung heraustritt, so daß es -bis der Tropfen auf die zu benetzende Verbindungsstelle trifftnicht durch den Luftsauerstoff oxidieren kann. Als Schutzmedium wird bevorzugt ein Inertgas, insbesondere Stickstoffgas, verwendet.

Nach einer Weiterbildung der Erfindung ist vorgesehen, daß die Schutzmediumaustrittsöffnung am Gehäuse des Aktors ausgebildet ist.

In bevorzugter Ausführungsform weist das Gehäuse des Aktors eine Eintrittsöffnung für das Schutzmedium auf. Das Schutzmedium kann also in das Gehäuse eingeleitet werden, dieses durchströmen und anschließend an der Schutzmediumaustrittsöffnung austreten, um den heißen flüssigen Mediumtropfen als Schutzatmosphäre zu umgeben.

Besonders bevorzugt wird ein Ausführungsbeispiel, bei dem die Eintrittsöffnung und die Austrittsöffnung für das Schutzmedium so im Gehäuse angeordnet sind, daß der Aktor zumindest bereichsweise im Strömungspfad des Schutzmediums liegt. Insbesondere kann dabei vorgesehen sein, daß das Schutzmedium beim Eintritt in das Gehäuse eine Temperatur derart aufweist, daß es als Kühlmedium für den Aktor dienen kann. Das Schutzmedium übernimmt also eine Doppelfunktion, in dem es einerseits den Aktor kühlt und andererseits als Oxidationsschutzmedium für das heiße flüssige Medium verwendet wird.

Besonders bevorzugt wird eine Ausführungsform, bei der der der thermischen Entkopplung zwischen dem Aktorgehäuse und der Mediumkammer dienende Schlitz als Schutzmediumaustrittsöffnung dient. Bei dieser Ausgestaltung ist vorteilhaft, daß das Schutzmedium, welches den Aktor kühlt, auch das Gehäuse in dem Bereich mitkühlen kann, der der Membran, also der Mediumkammer naheliegt. Somit wird aus diesem Bereich Wärme abgeführt, wodurch sich das Gehäuse im wesentlichen nicht aufheizt.

Nach einer Weiterbildung der Erfindung ist vorgesehen, daß -innerhalb des Gehäuses- für den Aktor eine Halteplatte vorgesehen ist, die etwa parallel zur Membran der Mediumkammer liegt. Die Halteplatte liegt vorzugsweise mit geringem Abstand zur Membran und weist etwa mittig einen Durchbruch auf, durch den der Aktor mit seinem Wärmesperrelement hindurchgreift. Somit wird der Aktor innerhalb des Gehäuses -wie vorstehend erwähnt- einerseits an der Gehäusewandung festgelegt und mit seinem anderen, der Membran zugewandten Ende durch die Halteplatte positionssicher gehalten.

Bevorzugt wird die Halteplatte mittels an der Gehäuseinnenseite ausgebildeten. Führungsschrägen gehalten und geführt. Die Halteplatte muß also nicht zwingend mit dem Gehäuse für den Aktor fest verbunden sein. Vielmehr sind die Schrägen an der Innenseite des Gehäuses so ausgebildet, daß die Halteplatte in einer definierten Position festgelegt ist. Insbesondere ist vorgesehen, daß die Halteplatte aus dem gleichen Material besteht wie das Gehäuse für den Aktor.

Nach einer Weiterbildung der Erfindung ist vorgesehen, daß der Mediumkammer eine Temperaturerfassungseinrichtung für die Mediumtemperatur zugeordnet ist. Die Temperaturerfassungseinrichtung wird vorzugsweise mittels eines Temperatursensors realisiert, der die Temperatur des flüssigen Mediums oder zumindest einer Wandung der Mediumkammer erfaßt. Der Temperatursensor ist vorzugsweise als Thermoelement oder als Dünnfilmsensor realisiert und vorzugsweise an der Membran außerhalb der Mediumkammer angebracht.

Weitere Ausgestaltungen ergeben sich aus den Unteransprüchen.

Ferner betrifft die Erfindung die Verwendung eines Druckkopfes mit einem oder mehreren der zuvor genannten Merkmale zum Aufbringen von metallischem Lot auf eine Lötverbindungsstelle, insbesondere eines mikromechanischen und/oder mikroelektronischen Elements.

In diesem Zusammenhang wird auch ein Verfahren aufgezeigt, welches nicht Bestandteil der Erfindung ist, mit dem Lot als heißes flüssiges Lot mittels einer nach dem Tintendruckprinzip arbeitenden Vorrichtung auf die Kontaktierstelle der Verbindungsstelle aufgespritzt wird. Nach diesem Verfahren ist es auf einfache Weise möglich, metallisches Lot auf eine Kontaktierstelle einer Verbindungsstelle aufzubringen, die für Verbindungstechniken beziehungsweise Verbindungsstellen im Bereich der Mikroelektronik und der Mikrosystemtechnik beziehungsweise Mikromechanik vorgesehen ist.

Bei dem Verfahren ist vorgesehen, daß das Lot als mindestens ein heißer flüssiger Tropfen aus der Vorrichtung ausgespritzt wird.

Beim Ausspritzen wird das Lot vorzugsweise mit einem Oxidationsschutzmedium, vorzugsweise Inertgas, umgeben. Dies verhindert, daß das heiße flüssige Lot bis zum Erreichen der Kontaktierstelle oxidiert.

Es wird die Temperatur des in der Vorrichtung vorliegenden heißen flüssigen Mediums erfaßt und überwacht. Somit kann die Ausspritztemperatur des Mediums optimal eingestellt werden, so daß hochwertige Verbindungsstellen herstellbar sind.

Es ist eine impulsartige, zum Ausspritzen mehrerer Tropfen dienende Ansteuerung vorgesehen. Werden die Tropfen aus einer Ausspritzöffnung ausgebracht, können somit mehrere Tropfen hintereinander ausgebracht werden. Selbstverständlich ist es auch möglich, das heiße flüssige Medium aus mehreren Austrittsöffnungen auszuspritzen, wobei es beispielsweise auch möglich ist, die Teilmediumkammern der einzelnen Ausspritzöffnungen zeitversetzt anzusteuern.

Als heißes flüssiges Medium können insbesondere sämtliche Weichlote aus der Elektronikfertigung verwendet werden, die beim Ausspritzen eine Temperatur zwischen 400 und 600°C aufweisen können. Selbstverständlich sind auch bleifreie Lote verwendbar. Es ist möglich, einzelne Tropfen mit etwa 4 pl bis 2 nl auszuspritzen. Somit können die hergestellten Verbindungsstellen mit einer genau definierten Lotmenge versehen werden.

Die Erfindung wird nachfolgend anhand von Ausführungsbeispielen mit Bezug auf die Zeichnung näher erläutert. Es zeigen:
- Figur 1: in geschnittener Seitenansicht einen Druckkopf,
- Figur 2: eine Draufsicht auf den Druckkopf der Figur 1,
- Figur 3: eine Rückansicht des Druckkopfes, und
- Figur 4: eine Halte- und Justierplatte des Druckkopfes.

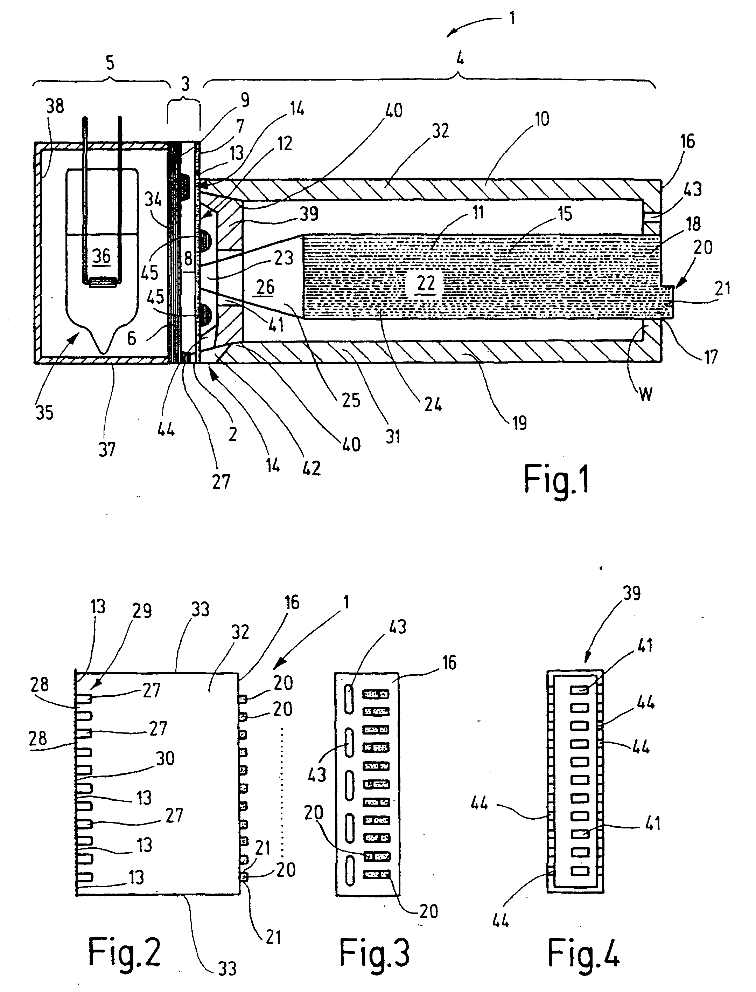

Figur 1 zeigt in geschnittener Seitenansicht schematisch einen Druckkopf 1, der nach dem an sich bekannten Prinzip des Tintendruckes arbeitet, mit dem also aus einer auch als Ausspritzöffnung bezeichneten Düse 2 ein flüssiges Medium vorzugsweise tropfenförmig auf ein mit Abstand zur Düse 2 liegendes zu beschichtendes Substrat aüfbringbar ist.

Der in Figur 1 dargestellte Druckkopf 1 ist in Modulweise aufgebaut und umfaßt mehrere Module. Im gezeigten Ausführungsbeispiel umfaßt der Druckkopf drei Module, nämlich einen sogenannten Druckchip 3, ein Aktormodul 4 und ein Heiz- und/oder Kühlmodul 5, welches im folgenden lediglich als Heizmodul bezeichnet wird. Diese drei Module sind separate Bauteile, die durch Zusammensetzen beziehungsweise Miteinanderverbinden den Druckkopf 1 bilden. Unter besonderen Voraussetzungen kann auf das Heizmodul 5 verzichtet werden. Hierauf wird jedoch erst später Bezug genommen. '

Der Grundkörper 6 des Druckchips 3 ist vorzugsweise aus einem Halbleitergrundwerkstoff, beispielsweise Silizium, hergestellt. Der auch als Substrat bezeichnete Grundkörper 6 bildet zusammen mit einer Membran 7 zumindest eine Mediumkammer 8 aus. Die Wandungen der Mediumkammer 8 werden also von dem Substrat 6 und der Membran 7 gebildet, wobei das Substrat 6 beziehungsweise der Grundkörper -im Querschnitt gesehen- im wesentlichen wannenartig ausgebildet ist und die Membran 7 die Öffnung des wannenartigen Grundkörpers 6 abdeckt. An der Innenseite 9 des Substrats 6 können mikromechanische Strukturen vorgesehen sein, die zur Mediumführung innerhalb der Mediumkammer 8 und zur Ausbildung mehrerer Teilmediumkammern dienen. Eine weitere mikromechanische Struktur bildet die Düse 2 der Mediumkammer 8.

Bevorzugt ist die Membran 7 aus Borosilikatglas hergestellt und mit den Wannenrändern des Grundkörpers 6 vorzugsweise durch anodisches Bonden verbunden. Alternativ ist es auch möglich, die Membran 7 aus Silizium herzustellen und durch das sogenannte Silicon-Fusion-Bonding mit den Wannenrändern des Grundkörpers 6 zu verbinden. Die Membran 7 ist also mit dem Grundkörper 6 fest verbunden.

Das auch als Betätigungseinrichtung bezeichnete Aktormodul 4 besitzt ein Gehäuse 10, welches einen Aktor 11 umgibt. Vorzugsweise ist das Gehäuse 10 aus einem elektrisch nicht und thermisch schlecht leitenden Material hergestellt. Vorzugsweise wird ein Material für das Gehäuse 10 gewählt, das annähernd denselben Wärmeausdehnungskoeffizienten besitzt wie der Werkstoff für den Aktor 11. Hierzu kann beispielsweise eine Keramik, insbesondere Zirkonoxid, vorgesehen sein. Das Gehäuse 10 weist an seiner der Membran 7 zugewandten Seite keine Gehäusewandung auf. Die Öffnung des Gehäuses 10 wird also von der Membran 7 abgedeckt. Zur Verbindung von Druckchip 3 und Aktormodul 4 ist vorgesehen, daß die Membran 7 zumindest im Bereich ihrer Berührstellen mit dem Gehäuse 10 vergoldet ist. Diese Vergoldung kann beispielsweise durch Bedampfen oder Sputtern aufgebracht werden. Gegebenenfalls kann zwischen der Vergoldung und der Membran zumindest eine sogenannte Haftvermittlerschicht vorgesehen sein. Die die Öffnung 12 des Gehäuses 10 umgebenden Ränder 13 (siehe auch Figur 2) sind vorzugsweise ebenfalls vergoldet ausgebildet. Dies kann beispielsweise mit einer goldhaltigen Dickschicht-Einbrennpaste realisiert werden. Zur Herstellung der eigentlichen Verbindung 14 ist dann vorgesehen, eine Goldschweiß- oder Lötverbindung zwischen Druckchip 3 und Aktormodul 4 herzustellen.

Wie vorstehend erwähnt, umgibt das Gehäuse 10 den Aktor 11. Der Aktor 11 ist als Lamelle, also als langer dünner Streifen ausgebildet, der im Querschnitt vorzugsweise rechteckig vorliegt. Der Aktor 11 ist ein Piezoelement 15, welches sich von der Gehäuserückseite 16 bis zur Membran 7 hin erstreckt und diese berührt. Die Gehäuserückwand 16 des Gehäuses 10 weist einen Durchbruch 17 auf, der von einem Ende 18 des Aktors 11 durchgriffen wird. Mit seinem Ende 18 ist der Aktor 11 innerhalb des Durchbruchs 17 vorzugsweise durch eine Klebung festgelegt. Das Gehäuse 10 bildet somit ein Stützelement beziehungsweise einen Tragkörper 19 für den Aktor 11. Am Ende 18 des Aktors 11 ist vorzugsweise noch ein Fortsatz 20 vorgesehen, der aus dem Gehäuse 10 herausragt, also über die Gehäuserückwand 16 hinaussteht. Der Fortsatz 20 ist an seiner dem Betrachter zugewandten Seite mit einem elektrischen Kontaktiermittel 21 versehen. Auch an der dem Betrachter abgewandten Seite des Fortsatzes 20, also der Seite, die nicht sichtbar parallel zur Zeichnungsebene liegt, ist er mit einem weiteren Kontaktiermittel versehen. Jedes Kontaktiermittel ist elektrisch leitend verbunden mit einer Aktivierungselektrode für den Aktor, wobei lediglich die dem Betrachter zugewandte Aktivierungselektrode 22 sichtbar ist. Die andere Aktivierungselektrode liegt parallel zu der Aktivierungselektrode 22 an der Seite des lamellenförmigen Aktors, die parallel zur Zeichnungsebene verläuft.

An seinem anderen Ende 23 steht der Aktor 11 in mechanischer Wirkverbindung mit der Membran 7. Aus Figur 1 ist ersichtlich, daß der Aktor 11 beziehungsweise das Piezoelement 15 nur bereichsweise mit Aktivierungselektroden bestückt ist. Somit bildet der Aktor 11 einen aktiven Teil 24 und einen passiven Teil 25. Am passiven Teil 25 sind entweder keine Aktivierungselektroden vorgesehen oder aber am Übergangsbereich zwischen aktivem und passivem Teil sind die Aktivierungselektroden unterbrochen, also elektrisch nicht miteinander verbunden. Der aktive Teil 24 des Aktors 11 ist im Ausführungsbeispiel wesentlich länger als der passive Teil 25 ausgebildet. Ausgehend von der Rückwand 16 erstreckt sich der Aktor 11 in Richtung zur Membran 7 mit seinem aktiven Teil 24, an den sich sein passiver Teil 25 anschließt, dessen Ende 23 an der Membran 7 anliegt. Der passive Teil 25 bildet ein Wärmesperrelement 26, so daß an der Membran 7 vorliegende Wärme keinen Einfluß auf den piezoelektrisch aktiven Teil 24 des Aktors 11 hat. Mithin ist der Aktor 11 beziehungsweise sein aktiver Teil 24 thermisch von der Membran 7 entkoppelt. Unter dem Wärmesperrelement 26 wird ein Element verstanden, das die Wärme schlecht leitet oder zumindest so ausgebildet ist, daß die an der Membran 7 vorliegende Wärme abgeschwächt beziehungsweise vermindert zum aktiven Teil 24 weitergeleitet wird. Um die schlechte Wärmeleitung zwischen Membran 7 und Aktor 11 noch zu erhöhen, ist vorzugsweise vorgesehen, daß der passive Teil 25 des Aktors 11 sich in Richtung der Membran 7 verjüngt. Somit liegt eine kleine Berührfläche zwischen Membran 7 und dem Aktor beziehungsweise dem Wärmesperrelement 26 vor, so daß eine kleine Wärmeübergangsfläche gegeben ist.

Der Aktor ist also einstückig ausgebildet, das heißt, daß der aktive und der passive Teil 24 und 25 aus demselben Material einstückig hergestellt sind.

Das Gehäuse 10 ist von der Membran 7 thermisch entkoppelt. Somit liegt ein geringer Wärmefluß von der Membran 7 zum Gehäuse 10 vor, so daß die an der Membran 7 vorliegende Wärme im wesentlichen nicht bis zur Gehäuserückwand 16 vordringen kann, die als Widerlager W für den Aktor 11 dient. Somit ist auch das Ende 18 des Aktors thermisch von der Membran entkoppelt, so daß eine Wärmebeeinflussung des aktiven Teils 24 gering gehalten ist. Zur thermischen Entkopplung zwischen Membran 7 und Gehäuse 10 ist insbesondere vorgesehen, daß die Ränder 13 des Gehäuses 7 geringe Berührflächen mit der Membran 7 aufweisen. Hierzu sind insbesondere mehrere Schlitze 27 vorgesehen, die randoffen ausgebildet sind. Die Schlitze und die dazwischen liegenden Zinken 28 bilden somit eine Kammstruktur 29 (Figur 2), so daß zwischen Membran 7 und Gehäuse 10 relativ geringe Wärmeübergängsflächen 30 vorliegen. Die Schlitze 27 erstrecken sich vorzugsweise an der unteren Gehäusewandung 31 und der oberen Gehäusewandung 32 des Gehäuses 10. Selbstverständlich können'auch an den seitlichen Gehäusewandungen 33 an dessen Rändern derartige Schlitze beziehungsweise Kammstrukturen vorgesehen sein. Die Schlitze 27 erstrecken sich -ausgehend von den Rändern 13- etwa rechtwinklig zur Membran. Die Schlitze 27 erstrecken sich nur bereichsweise in den Gehäusewandungen, also nicht bis zur Gehäuserückwand 16. Der Tragkörper 19 ist also vorzugsweise so geformt, daß die Schlitze 27 beziehungsweise Kammstrukturen, der Durchbruch 17 und die Schutzmediumeintrittsöffnung 43 von vorn oder hinten einbringbar sind, also keine seitlichen Öffnungen ausgebildet werden müssen. Hierdurch läßt sich der Tragkörper 18 sehr einfach in einer Gußform herstellen.

Dadurch, daß die Schlitze 27 vorgesehen sind, besitzt das Gehäuse 10 auch eine Wärmeausdehnungskompensation. Obwohl durch die kleinen Berührflächen 30 eine thermische Entkopplung zwischen Membran 7 und Gehäuse 10 vorliegt, erwärmt sich dennoch das Gehäuse 10 in seinem der Membran benachbart liegenden Bereich. Um ein "Verziehen" des Gehäuses 10 beziehungsweise des Tragkörpers 19 zu vermindern beziehungsweise zu vermeiden, dienen die Schlitze 27 der Wärmeausdehnungskompensation. Es ist insbesondere aus Figur 1 ersichtlich, daß sich die Gehäusewandungen 31, 32 oder 33 zu den Rändern 13 hin verjüngen.

An seiner der Membran 7 abgewandten Seite ist am Grundkörper 6 das Heizmodul 5 vorgesehen. Das Heizmodul 5 liegt also an dem Wannenboden 34 des Grundkörpers 6 zugewandt. Das Heizmodul 5 umfaßt eine Wärmequelle 35, die von einer Lichtquelle 36 gebildet sein kann. Bevorzugt wird für die Lichtquelle 36 eine Halogenlampe verwendet. Mittels der Wärmequelle 35 kann ein in der Mediumkammer 8 vorliegendes metallisches Medium derart erhitzt werden, daß es in flüssiger Phase vorliegt, so daß es durch die Düse 2 aus dem Druckchip 3 ausgebracht werden kann. Um den Wirkungsgrad der Wärmequelle 35 zu erhöhen, ist vorzugsweise vorgesehen, daß die Wärmequelle 35 von einer Einhäusung 37 umgeben ist, die von dem Wannenboden 34 verschlossen ist. An der Innenseite der Einhäusung 37 ist eine Verspiegelung 38 aufgebracht, die die von der Wärmequelle 35 ausgehende Wärmestrahlung in Richtung des Wannenbodens 34 reflektiert. Somit kann die von der Wärmequelle 35 erzeugte Wärme im wesentlichen nicht aus der Einhäusung 37 austreten. Es kann auch vorgesehen sein, daß die Einhäusung 37 aus einem schlecht wärmeleitenden Material hergestellt ist. Für die Anordnung der drei Module 3, 4, 5 ist eine Reihenanordnung gewählt, so daß die Wärmequelle 35 nicht direkt auf den Aktor 11 einwirken kann.

Für den Druckkopf 1 ergibt sich folgende Funktionsweise:

Der Druckkopf 1 wird zum Ausspritzen eines heißen flüssigen Mediums verwendet, welches zumindest in der Mediumkammer 8 heiß und in der flüssigen Phase vorliegt. Durch die Aktivierung des Aktors 11 wird die Membran 7 in Richtung des Wannenbodens 34 ausgelenkt beziehungsweise durchgebogen, so daß sich das Volumen der Mediumkammer 8 verringert. Dadurch wird ein der Volumenverringerung der Mediumkammer 8 proportionaler Anteil des heißen flüssigen Mediums aus der Düse 2 herausgedrückt. Durch eine anschließende Deaktivierung des Aktors 11 wird die Membran wieder von dem Wannenboden 34 zurückgezogen, wodurch aus der Düse 2 das heiße flüssige Medium als Tropfen ausgebracht wird. Die Auslenkung der Membran 7 wird durch die elektrische Aktivierung des Piezoelements 15 erreicht. Durch Anlegen einer elektrischen Spannung an die Aktivierungselektroden ändert das lamellenförmige Piezoelement 15 seine räumliche Gestalt. Je nachdem, mit welcher Polarität die Aktivierungselektroden angesteuert werden, verlängert oder verkürzt sich der aktive Teil 24 des Piezoelements. Somit kann die Membran in Richtung des Wannenbodens 34 durchgebogen oder herausgebogen beziehungsweise gewölbt werden. Somit ist klar, daß sich durch die Ansteuerung des Aktors 11 beziehungsweise des Piezoelements 15 das Volumen in der Mediumkammer 8 ändert. Durch impulsartige Ansteuerung des Aktors 11 können somit mehrere Tropfen des heißen flüssigen Mediums aus der Düse 2 nacheinander ausgebracht werden. Je nach Ansteuerungsfrequenz können diese Tropfen sehr schnell hintereinander aus der Düse 2 ausgespritzt werden. Je nach Energieeintrag an die Aktivierungselektroden kann die Stärke der Auslenkung der Membran 7 beeinflußt werden.

Um das Volumen der einzeln ausgebrachten Tropfen im wesentlich konstant zu halten, ist es wichtig, daß der Aktor 11 von äußeren Einflüssen, beispielsweise Wärme oder mechanischer Verformung freigehalten wird, so daß die Membran 7 bei jeder Ansteuerung beziehungsweise Auslenkung denselben Weg zurücklegt. Um den Wärmeeinfluß zu dem Aktor 11 möglichst gering zu halten, ist -wie vorstehend erwähnt- das Wärmesperrelement 26 vorgesehen. Zur Verminderung von mechanischen Einflüssen auf das Piezoelement 15 ist -wie vorstehend erwähnt- auch das Gehäuse 10 beziehungsweise der Tragkörper 19 des Aktors 11 wärmetechnisch von der Membran 7 entkoppelt und weist außerdem die vorstehend beschriebene Wärmeausdehnungskompensation auf.

Um die mechanische Stabilität und Ausrichtung der Aktoren 11 zu erhöhen, ist innerhalb des Gehäuses 10 eine sogenannte Justier- und Halteplatte 39 vorgesehen, die im Querschnitt im wesentlichen C-förmig ausgebildet ist. Die Justier- und Halteplatte, die im folgenden lediglich als Halteplatte 39 bezeichnet wird, ist durch Schrägen 40 an der Gehäuseinnenseite geführt und somit exakt ausgerichtet. Mit den freien Enden der Schenkel des C's liegt die Halteplatte 39 an der dem Gehäuse 10 zugewandten Seite der Membran 7 an. Etwa mittig in der Basis des C's weist die Halteplatte einen Durchbruch 41 auf, durch den der Aktor 11 mit seinem Wärmesperrelement 26 hindurchgreift. Der Durchbruch 41 ist so dimensioniert, daß der Aktor 11 zwar geführt ist, bei seiner Längenveränderung durch die Ansteuerung der Aktivierungselektroden jedoch nicht beeinträchtigt wird. Vorzugsweise ist die Halteplatte 39 aus demselben Material hergestellt wie das Gehäuse 10.

Bei einem bevorzugten Ausführungsbeispiel weist der Druckkopf 1 eine Schutzmediumaustrittsöffnung 42 auf, die so ausgerichtet ist, daß ein aus der Schutzmediumaustrittsöffnung austretendes Schutzmedium in Richtung der Mündung der Düse 2 strömt. Als Schutzmedium wird vorzugsweise ein die Oxidation des aus der Düse 2 austretenden heißen flüssigen Mediums verhinderndes Schutzmedium, insbesondere Inertgas, verwendet. Als Inertgas kann beispielsweise Stickstoffgas verwendet werden. Dadurch, daß der beziehungsweise die aus der Düse 2 austretenden Tropfen mit einer Schutzatmosphäre aus dem Schutzmedium umgeben werden, wird während des "Fluges" des Tropfens verhindert, daß dieser oxidiert. Dies ist insbesondere dann wichtig, wenn aus der Mediumkammer 8 als heißes flüssiges Medium ein metallisches Lot auf ein eine Verbindungsstelle aufweisendes Substrat aufgebracht werden soll. Bevorzugt besitzt das Gehäuse 10 eine Schutzmediumeintrittsöffnung 43, die beispielsweise an der Gehäuserückwand 16 vorliegen kann. Durch die Schutzmediumeintrittsöffnung 43 kann das Schutzmedium in das Gehäuse 10 eingeleitet werden, um nach Durchströmung des Gehäuses 10 an der Schutzmediumaustrittsöffnung 42 wie vorstehend beschrieben auszutreten. Insbesondere ist vorgesehen, daß die Schutzmediumeintrittsöffnung 43 und die Schutzmediumaustrittsöffnung 42 so am Gehäuse angeordnet sind, daß der Aktor 11, insbesondere dessen aktiver Teil 24, im Strömungspfad des Schutzmediums liegt. Somit dient das Schutzmedium auch als Kühlmedium für den Aktor. Besonders bevorzugt wird als Schutzmediumaustrittsöffnung ein Schlitz 27 der Kammstruktur 29 gewählt. Besonders bevorzugt wird der Strömungspfad für das Schutzmedium innerhalb des Gehäuses 10 so gewählt, daß das Schutzmedium an der Schutzmediumeintrittsöffnung 43 an der Gehäuserückwand 16 eintritt, den Aktor 11 umströmt, durch den Durchbruch 41 an der Halteplatte hindurchtritt, durch Schlitze 44 an den Schenkeln des C's der Halteplatte hindurchströmt und so zur Schutzmediumaustrittsöffnung 42 gelangt. Die Schlitze 44 liegen dabei vorzugsweise deckungsgleich mit den Schlitzen 27 an dem Gehäuse 10. Selbstverständlich wäre auch ein Strömungspfad denkbar, bei dem die Schenkel der Halteplatte 39 so ausgebildet sind, daß zwischen den Führungsschrägen 40 zwischen Halteplatte 39 und Gehäuse 10 ein Strömungskanal vorliegt, der in der Schutzmediumaustrittsöffnung 42 mündet.

Im vorliegenden Ausführungsbeispiel wurde das in der Mediumkammer 8 vorliegende Medium, insbesondere metallisches Lot, mittels der Wärmequelle 35 erwärmt. Denkbar wäre auch, daß das aus der Mediumkammer 8 auszuspritzende heiße flüssige Medium bereits in flüssiger Phase der Mediumkammer 8 zugeführt wird. Gegebenenfalls kann dann auf das Heizmodul 5 verzichtet werden.

Um mit dem Druckkopf 1 auch sehr kalte flüssige Medien ausspritzen zu können, kann auch eine Kühleinrichtung vorgesehen sein, die beispielsweise dem Wannenboden 34 zugeordnet ist. Hierzu kann eine Wärmesenke, insbesondere ein Peltierelement, vorgesehen sein. Selbstverständlich ist es auch möglich, sowohl eine Wärmequelle beziehungsweise Heizeinrichtung als auch eine Kühleinrichtung beziehungsweise Wärmesenke vorzusehen.

Anstelle der Lichtquelle 36 können für die Wärmequelle 35 auch Heizwiderstände (nicht dargestellt) vorgesehen sein, die an der Außenseite der Mediumkammer 8 an dem Wannenboden 34 vorliegen. Vorzugsweise werden diese Heizwiderstände in Dünnschicht-Technik auf das Substrat beziehungsweise den Grundkörper 6 aufgebracht. Die Heizwiderstände umfassen vorzugsweise Hafniumdiborid.

Um die Mediumtemperatur des in der Mediumkammer 8 vorliegenden Mediums zu erfassen und zu überwachen, kann insbesondere an der Membran 7 zumindest ein Temperaturerfassungselement 45 vorgesehen sein, das zwischen Membran 7 und Halteplatte 39, also außerhalb der Mediumkammer 8 vorliegt.

Die zumindest eine Temperaturerfassungseinrichtung 45 kann beispielsweise als Temperatursensor ausgebildet sein, der von einem Thermoelement oder von einem Dünnfilmsensor gebildet ist.

Im folgenden wird ein Verfahren zur Herstellung einer metallisches Lot umfassenden Verbindungsstelle beschrieben. Die Verbindungsstelle besitzt eine auch als Kontaktpad bezeichnete Kontaktierstelle, die mit metallischem Lot benetzt werden soll. Hierzu wird vorzugsweise der vorstehend beschriebene Druckkopf 1 zum Ausspritzen des flüssigen Lotes, welches beispielsweise eine Zinn-Blei- oder Zinn-Gold-Legierung sein kann, verwendet. Selbstverständlich können insbesondere sämtliche aus der Elektronikfertigung bekannte Weichlote verwendet werden. Das in der Mediumkammer 8 vorliegende heiße flüssige Lot wird durch die Auslenkung der Membran 7 tropfenförmig aus der Düse 2 auf die Kontaktierstelle der Verbindungsstelle aufgebracht. Hierzu wird das in der Mediumkammer 8 vorliegende heiße flüssige Lot als mindestens ein heißer flüssiger Tropfen aus dem Druckkopf aus der Düse 2 ausgespritzt. Um ein Oxidieren des heißen flüssigen Lottropfens zu verhindern, wird der Tropfen mit einem Oxidationsschutzmedium, welches aus der Schutzmediumaustrittsöffnung 2 ausgebracht wird, umgeben. Um eine optimale Benetzung der Kontaktierstelle der Verbindungsstelle zu gewährleisten, wird die Lottemperatur innerhalb der Mediumkammer 8 mittels der Temperaturerfassungseinrichtung 45 überwacht. Somit kann in Abhängigkeit von der erfaßten Temperatur die Wärmequelle 35 so angesteuert werden, beispielsweise ein- oder ausgeschaltet werden, daß innerhalb der Mediumkammer 8 das Lot auf der gewünschten Temperatur gehalten wird. Insbesondere wird zur Ausspritzung des heißen flüssigen Lots die Temperatur innerhalb der Mediumkammer auf zirka 400 bis 600°C gehalten.

Somit ist es auf besonders einfache und kostengünstige Art und Weise möglich, Verbindungstechniken der Mikroelektronik, Mikromechanik beziehungsweise Mikrosystemtechnik zu vereinfachen. Insbesondere kann das Tape-Automated-Bonding (TAB), das Chip-Size-Packaging (CSP) und insbesondere die sogenannte Flip-Chip-Verbindung (FC) vereinfacht werden. Bei diesen Verbindungstechniken werden als Verbindungselemente zwischen Bauelemente und Substrat sogenannte Bumps (Lotdepots) benötigt. Diese meist höckerförmigen Lotdepots können besonders einfach mit dem vorstehend beschriebenen erfindungsgemäßen Druckkopf hergestellt werden.

Zur Erzeugung dieser Lotdepots können auch mehrere Tropfen hintereinander aus der Düse 2 ausgebracht werden. Hierzu ist -wie vorstehend erwähnt- die impulsartige Ansteuerung des Aktors 11 vorgesehen, so daß die Membran 7 schnell hin- und herbewegt werden kann, wodurch die einzelnen Tropfen aus der Düse 2 ausgebracht werden können.

Selbstverständlich ist es möglich, einen Druckkopf 1 zu verwenden, der mehrere Düsen 2 aufweist, wobei insbesondere vorgesehen ist, daß die Düsen matrixartig angeordnet sind. Beispielsweise können mehrere Düsen 2 hintereinander in Reihe liegen, also in zur Zeichnungsebene parallelen Ebenen. Wird ein mehrdüsiger Druckkopf 1 verwendet, so sind vorzugsweise mehrere Teilmediumkammern vorgesehen, wobei jeweils einer Teilmediumkammer vorzugsweise mindestens eine Düse 2 zugeordnet ist. Jede Teilmediumkammer weist vorzugsweise eine separate Membran 7 auf, wobei jede Membran von jeweils einem Aktor 11 angesteuert wird. Mit anderen Worten: sämtliche Düsen beziehungsweise sämtliche Membranen sind unabhängig voneinander über zumindest jeweils einen Aktor 11 ansteuerbar. Wird ein mehrdüsiger Druckkopf 1 verwendet, wird eine Anordnung der Aktoren bevorzugt, wie dies in Figur 2 dargestellt ist. Die Aktoren 11 liegen in Reihe nebeneinander, so daß ihre Fortsätze 20 nebeneinander aus der Gehäuserückwand 16 herausragen. Dabei ist vorgesehen, daß an jeder Seite des Fortsatzes 20 die Kontaktiermittel 21 vorgesehen sind, so daß außerhalb des Gehäuses eine Kontaktierung der Aktivierungselektroden erfolgen kann. Wie aus Figur 3 ersichtlich, liegen die Fortsätze 20 zweier benachbarter Aktoren 11 versetzt zueinander, so daß für Gegenkontaktiermittel genügend Platz geschaffen wird, um die Kontaktiermittel 21 elektrisch leitend mit den Gegenkontaktiermitteln zu verbinden. Aus Figur 3 ist noch ersichtlich, daß mehrere Schutzmediumeintrittsöffnungen 43 an der Gehäuserückwand 16 vorgesehen sein können. Insbesondere kann vorgesehen sein, daß eine Mediumeintrittsöffnung 43 für zwei Aktoren 11 vorgesehen ist. Denkbar wäre, daß innerhalb des Gehäuses 10 zwischen unterer und oberer Gehäusewandung 31 und 32 verlaufende Trennwände vorliegen, die die einzelnen Aktoren 11 räumlich voneinander trennen.

In Figur 4 ist in Draufsicht die Halteplatte 39 dargestellt. Es ist ersichtlich, daß mehrere Schlitze 44 an beiden Schenkeln der C-förmigen Halteplatte vorgesehen sein können. Die Schlitze 44 sind so in den Schenkeln der Halteplatte 39 eingebracht, daß sie vorzugsweise deckungsgleich mit den Schlitzen 27 am Gehäuse 10 liegen, wie dies in Figur 1 dargestellt ist. Es ist nicht zwingend erforderlich, die Schlitze 27 am Gehäuse sowohl an der unteren als auch an der oberen Gehäusewandung 31 und 32 auszubilden. Insbesondere genügt es, wenn an der unteren Gehäusewandung 31 die Schlitze 27 vorliegen, um die Schutzmediumaustrittsöffnungen 42 auszubilden.

Im folgenden wird noch ein Verfahren zur Herstellung eines nach dem Tintendruckprinzip arbeitenden Druckkopfes 1 beschrieben, der zumindest den Druckchip 3 und das Aktormodul 4 umfaßt. Zusätzlich kann das Heizmodul 5 vorgesehen sein. Bei der Herstellung ist vorgesehen, daß der Aktor 11 beziehungsweise das Aktormodul 4 thermisch entkoppelt miteinander verbunden werden. Der Druckchip 3 wird insbesondere als mikromechanische Strukturen aufweisendes Siliziumsubstrat hergestellt, wobei die mikromechanischen Strukturen zur Mediumführung und zur Ausbildung einer Ausspritzöffnung beziehungsweise Düse 2 vorgesehen sind. Das Siliziumsubstrat wird vorzugsweise wannenförmig ausgebildet, wobei die mikromechanischen Strukturen für die Mediumführung an der Innenseite des wannenförmigen Siliziumsubstrats liegen. Die Düse ist demnach als Öffnung von der Innenseite zur Außenseite des Siliziumsubstrats ausgebildet. Die Öffnung des wannenartigen Siliziumsubstrats wird mit der Membran 7 zur Ausbildung der Mediumkammer 8 abgedeckt. Dabei wird die Membran 7 vorzugsweise durch anodisches Bonden mit dem Siliziumsubstrat verbunden, sofern die Membran 7 aus Borosilikatglas besteht. Wird die Membran aus Silizium hergestellt, erfolgt die Verbindung zwischen Membran 7 und Substrat beziehungsweise Grundkörper 6 durch sogenanntes Silicon-Fusion-Bonding. Beim Zusammensetzen beziehungsweise Verbinden des Aktormoduls 4 und Druckchips 3 wird vorzugsweise zunächst der Aktor 11 in den diesen haltenden Tragkörper 19 beziehungsweise Gehäuse 10 eingesetzt, wobei anschließend der Tragkörper mit der Membran verbunden wird, und zwar auf der Seite, die der Wannenöffnung des Grundkörpers 6 gegenüberliegt. Zur Verbindung zwischen Membran 7 und Tragkörper 19 ist vorgesehen, daß die Membran 7 durch Bedampfen und Sputtern vergoldet wird, insbesondere in dem Bereich, der der späteren Verbindungsstelle zwischen Membran 7 und Gehäuse 10 zugeordnet ist. Die Ränder 13 des Tragkörpers werden vor der Verbindung mit der Membran vorzugsweise ebenfalls vergoldet, wobei hierzu eine Dickschicht-Einbrennpaste vorgesehen ist, die Gold aufweist. Die Verbindung zwischen Tragkörper 19 und Membran 7 erfolgt vorzugsweise durch eine Goldschweiß- oder Lötverbindung.

Der Tragkörper 19 beziehungsweise das Gehäuse 10 wird aus Zirkonoxid vorzugsweise im sogenannten Heißgießverfahren hergestellt, wobei die Durchbrüche 17, Schlitze 27 und Führungsschrägen 40 beim Gießvorgang mit ausgebildet werden können. Alternativ ist auch eine Behandlung beziehungsweise Bearbeitung nach dem Sintern der Keramik zur Ausbildung der Schlitze 27, Führungsschrägen 40 und Schutzmediumeintrittsöffnung 43 möglich.

Zur lagerichtigen Montage des Aktors 11 innerhalb des Tragkörpers wird die vorstehend erwähnte Justier- und Halteplatte 39 verwendet, die nach dem Einkleben des Aktors 11 im Durchbruch 17 über das Wärmesperrelement 26 aufgesetzt wird, so daß das Wärmesperrelement den Durchbruch 41 an der Halteplatte 39 durchgreift. Beim Einsetzen der Halteplatte 39 wird diese mittels der Führungsschrägen 40 positionsgenau und sicher im Tragkörper 19 beziehungsweise Gehäuse 10 gehalten. Der Aktor wird dabei zwischen seinem Widerlager W an der Gehäuserückwand 64 und der Halteplatte 39 so gehalten, daß sein freies Ende 23 auf die Membran wirken kann, so daß diese auslenkbar ist.

Ein weiterer Herstellungsschritt besteht darin, daß der Membran ein Temperatursensor zugeordnet wird, der als Thermoelement oder Dünnfilmsensor ausgebildet ist. Vorzugsweise wird der Temperatursensor vor dem Aufsetzen des Aktormoduls 4 auf die Membran aufgebracht. Der Temperatursensor kann als diskretes Bauelement oder in Dünnfilmtechnik durch Bedampfen oder Sputtern und durch litographisches Strukturieren hergestellt beziehungsweise geformt werden.

Auf dem Siliziumsubstrat, insbesondere an der Außenseite des Wannenbodens 34, können Heizwiderstände in Dünnschicht-Technik aufgebracht werden. Vorzugsweise wird als Widerstandsmaterial Hafniumdiborid durch Sputtern aufgebracht und durch anschließendes litographisches Strukturieren geformt.

Mit dem vorstehend beschriebenen Druckkopf 1, der nach dem Tintendruckprinzip arbeitet, ist es in vorteilhafter Weise möglich, das Anwendungsgebiet derartiger Tintendruckköpfe zu erweitern, so daß Verbindungsstellen in der Mikroelektronik beziehungsweise Mikromechanik und Mikrosystemtechnik einfach hergestellt werden können. Denkbar wäre beispielsweise auch die Verwendung eines herkömmlichen Tintendruckkopfes, sofern dieser Tintendruckkopf ein wärmeunempfindliches Aktorelement besitzt. Bevorzugt wird jedoch der vorstehend beschriebene Druckkopf verwendet, der ein von der Mediumkammer thermisch entkoppeltes Aktorelement besitzt.

## Patentansprüche

1. Druckkopf (1) zum Ausspritzen eines heißen flüssigen Mediums, mit einer Membran (7), die eine Wandung einer Mediumkammer (8) bildet, und mit einem mit der Membran (7) in mechanischem Kontakt stehenden Aktor (11), der von einem Piezoelement (15) gebildet ist, wobei das Piezoelement (15) mittels eines Wärmesperrelements (26) von der Membran (7) thermisch entkoppelt ist, **dadurch gekennzeichnet, dass** das Wärmesperrelement (26) einstückiger Bestandteil des Piezoelements (15) ist, dass das Piezoelement (15) einen aktiven und einen das Wärmesperrelement (26) bildenden passiven Bereich (24,25) aufweist, dass der aktive Bereich (24) des Piezoelements (15) Elektroden (22) aufweist und dass der passive Bereich (25) elektrodenlos ausgebildet ist, oder dass die Elektroden (22) am Übergangsbereich zwischen aktivem und passivem Bereich (24,25) unterbrochen sind.

2. Druckkopf nach Anspruch 1, **dadurch gekennzeichnet, dass** der Querschnitt im Bereich des Wärmesperrelements (26) kleiner als im übrigen Bereich des Aktors (11) ist.

3. Druckkopf nach einem der vorhergehenden Ansprüche, **dadurch gekennzeichnet, dass** die übrigen Wandungen der Mediumkammer (8) von einem Silizium umfassenden Substrat (6) gebildet sind.

4. Druckkopf nach einem der vorhergehenden Ansprüche, **dadurch gekennzeichnet, dass** der Aktor (11) von einem Gehäuse (10) umgeben ist.

5. Druckkopf nach Anspruch 4, **dadurch gekennzeichnet, dass** der Aktor (11) als Lamelle ausgebildet ist und sich zwischen der Membran (7) und einer ein Widerlager (W) für den Aktor (11) bildenden Gehäusewand (16) erstreckt.

6. Druckkopf nach einem der Ansprüche 4 und 5, **dadurch gekennzeichnet, dass** das Gehäuse (10) elektrisch isolierend und/oder schlecht wärmeleitend ausgebildet ist.

7. Druckkopf nach einem der Ansprüche 4 bis 6, **dadurch gekennzeichnet, dass** das Gehäuse (10) aus einem Werkstoff hergestellt ist, der einen ähnlichen, vorzugsweise gleichen, Wärmeausdehnungskoeffizienten besitzt wie die Piezokeramik des Aktors (11).

8. Druckkopf nach einem der vorhergehenden Ansprüche, **dadurch gekennzeichnet, dass** die Membran (7) der Mediumkammer (8) eine Gehäusewand bildet.

9. Druckkopf nach einem der Ansprüche 4 bis 8, **dadurch gekennzeichnet, dass** das Gehäuse (10) von der Mediumkammer (8) thermisch entkoppelt ist.

10. Druckkopf nach einem der Ansprüche 4 bis 9, **dadurch gekennzeichnet, dass** das Gehäuse (10) eine Wärmeausdehnungskompensation besitzt.

11. Druckkopf nach einem der vorhergehenden Ansprüche, **gekennzeichnet durch** eine Heizeinrichtung (35) für das Medium.

12. Druckkopf nach einem der vorhergehenden Ansprüche, **gekennzeichnet durch** eine Kühleinrichtung.

13. Druckkopf nach einem der Ansprüche 11 und 12, **dadurch gekennzeichnet, dass** die Heizeinrichtung (35) und/oder Kühleinrichtung der Mediumkammer (8) zugeordnet ist.

14. Druckkopf nach einem der Ansprüche 11 bis 13, **dadurch gekennzeichnet, dass** die Heiz- und/oder Kühleinrichtung von einer Einhäusung (37) umgeben ist.

15. Druckkopf nach Anspruch 14, **dadurch gekennzeichnet, dass** eine Wandung (34) der Einhäusung (37) von dem Substrat (6) gebildet ist.

16. Druckkopf nach einem der Ansprüche 14 und 15, **dadurch gekennzeichnet, dass** die Einhäusung (37) von dem Substrat (6) thermisch entkoppelt ist.

17. Druckkopf nach einem der vorhergehenden Ansprüche, **dadurch gekennzeichnet, dass** die Mediumkammer (8) mindestens eine, insbesondere mehrere Ausspritzöffnungen (2) für das heiße flüssige Medium besitzt.

18. Druckkopf nach einem der vorhergehenden Ansprüche, **gekennzeichnet durch** eine Schutzmediumaustrittsöffnung (42) für ein die Oxidation des heißen flüssigen Mediums verhinderndes, eine Schutzatmosphäre bildendes Schutzmedium.

19. Druckkopf nach Anspruch 18 und einem der Ansprüche 4 bis 10, **dadurch gekennzeichnet, dass** die Schutzmediumaustrittsöffnung (42) am Gehäuse (10) des Aktors (11) vorgesehen ist.

20. Druckkopf nach einem der Ansprüche 4 bis 10 oder 19, **dadurch gekennzeichnet, dass** das Gehäuse (10) eine Eintrittsöffnung (43) für das Schutzmedium besitzt.

21. Druckkopf nach Anspruch 20, **dadurch gekennzeichnet, dass** die Eintrittsöffnung (43) und die Austrittsöffnung (42) so im Gehäuse (10) angeordnet sind, dass der Aktor (11) zumindest bereichsweise im Strömungspfad des Schutzmediums liegt.

22. Druckkopf nach einem der Ansprüche 9, 10 oder 19 bis 21, **dadurch gekennzeichnet, dass** die thermische Entkopplung zwischen Gehäuse (10) und Mediumkammer (8) und/oder die Wärmeausdehnungskompensation des Gehäuses (10) durch einen oder mehrere Schlitze (27) im Gehäuse (10) realisiert ist.

23. Druckkopf nach Anspruch 22, **dadurch gekennzeichnet, dass** zumindest ein Schlitz (27) als Schutzmediumaustrittsöffnung (42) dient.

24. Druckkopf nach einem der Ansprüche 22 und 23, **dadurch gekennzeichnet, dass** die Schlitze (27) eine Kammstruktur (29) am Gehäuserand (13) bilden.

25. Druckkopf nach einem der Ansprüche 4 bis 10 oder 19 bis 24, **dadurch gekennzeichnet, dass** innerhalb des Gehäuses (10) eine Halteplatte (39) für den Aktor (11) vorgesehen ist, die etwa parallel zur Membran (7) liegt, und dass der Aktor (11) die Halteplatte (39) mit seinem der Membran (7) zugewandten Wärmesperrelement (26) durchgreift.

26. Druckkopf nach Anspruch 25, **dadurch gekennzeichnet, dass** die Halteplatte (39) mittels an der Gehäuseinnenseite ausgebildeten Führungsschrägen (40) gehalten und geführt ist.

27. Druckkopf nach einem der vorhergehenden Ansprüche, **dadurch gekennzeichnet, dass** der Mediumkammer (8) eine Temperaturerfassungseinrichtung (45) für die Mediumtemperatur zugeordnet ist.

28. Verwendung eines Druckkopfes nach einem der Ansprüche 1 bis 27 zum Aufbringen von metallischem Lot auf eine Lötverbindungsstelle, insbesondere eines mikromechanischen und/oder mikroelektronischen Elements.

## Claims

1. Printhead (1) for jetting a hot liquid medium, with a membrane (7) that forms a wall of a medium chamber (8), and with an actuator (11), which is in mechanical contact with the membrane (7), that is formed by a piezoelement (15), with the piezoelement (15) being thermally decoupled from the membrane (7) by means of a heat blocking element (26), **characterized in that** the heat blocking element (26) is an integral component of the piezoelement (15), that the piezoelement (15) has an active zone and a passive zone (24,25), the latter forming the heat blocking element (26), that the active zone (24) of the piezoelement (15) having electrodes (22) and that the passive zone (25) is configured without electrodes, or that the electrodes (22) at the transition zone between active and passive zone (24,25) are interrupted.

2. Printhead according to claim 1, **characterized in that** the cross section in the zone of the heat blocking element (26) is smaller than in the remaining area of the actuator (11).

3. Printhead according to one of the preceding claims **characterized in that** the other walls of the medium chamber (8) are formed by a substrate (6) comprising silicon.

4. Printhead according to one of the preceding claims **characterized in that** the actuator (11) is surrounded by a housing (10).

5. Printhead according to claim 4 **characterized in that** the actuator (11) is configured as lamella and extends between the membrane (7) and a housing wall (16) forming a support (W) for the actuator (11).

6. Printhead according to one of claims 4 and 5 **characterized in that** the housing (10) is configured to be electrically insulating and/or to conduct heat poorly.

7. Printhead according to of one of claims 4 to 6 **characterized in that** the housing (10) is produced from a material which has a similar, preferably the same, heat expansion coefficient as the piezoceramic of the actuator (11).

8. Printhead according to one of the preceding claims **characterized in that** the membrane (7) of the medium chamber (8) forms a housing wall.

9. Printhead according to one of claims 4 to 8 **characterized in that** the housing (10) is thermally decoupled from the medium chamber (8).

10. Printhead according to one of claims 4 to 9 **characterized in that** the housing (10) has a heat expansion compensation.

11. Printhead according to one of the preceding claims **characterized by** a heating device (35) for the medium.

12. Printhead according to one of the preceding claims **characterized by** a cooling device.

13. Printhead according to one of claims 11 and 12 **characterized in that** the heating device (35) and/or the cooling device is assigned to the medium chamber (8).

14. Printhead according to one of claims 11 to 13 **characterized in that** the heating and/or cooling device is surrounded by a housing (37).

15. Printhead according to claim 14 **characterized in that** a wall (34) of the housing (37) is formed from the substrate (6).

16. Printhead according to one of claims 14 and 15 **characterized in that** the housing (37) is thermally decoupled from the substrate (6).

17. Printhead according to one of the preceding claims **characterized in that** the medium chamber (8) has at least one, in particular several jet openings (2) for the hot liquid medium.

18. Printhead according to one of the preceding claims **characterized by** a protective medium outlet (42) for a protective medium that forms a protective atmosphere which prevents the oxidation of the hot liquid medium.

19. Printhead according to claim 18 and to one of claims 4 to 10 **characterized in that** the protective medium outlet (42) is provided on the housing (10) of the actuator (11).

20. Printhead according to claims 4 to 10 or 19 **characterized in that** the housing (10) has an inlet (43) for the protective medium.

21. Printhead according to claim 20 **characterized in that** the inlet (43) and the outlet (42) are arranged in the housing (10) such that the actuator (11) lies at least in some areas in the flow path of the protective medium.

22. Printhead according to one of claims 9, 10 or 19 to 21 **characterized in that** the thermal decoupling between housing (10) and medium chamber and/or the heat expansion compensation of the housing (10) is realized through one or more slits (27) in the housing (10).

23. Printhead according to claim 22 **characterized in that** at least one slit (27) serves as protective medium outlet (42).

24. Printhead according to one of claims 22 and 23 **characterized in that** the slits (27) form a comb structure (29) on the housing edge (13).

25. Printhead according to one of the claims 4 to 10 or 19 to 24 **characterized in that** inside of the housing (10) a retaining plate (39) is provided for an actuator (11) which lies approximately parallel to the membrane (7) and that the actuator (11) with its heat blocking element (26) turned toward the membrane (7) penetrates the retaining plate (39).

26. Printhead according to claim 25 **characterized in that** the retaining plate (39) is retained and guided by means of guide slopes (40) configured on the interior of the housing.

27. Printhead according to one of the preceding claims **characterized in that** a temperature-measuring device (45) for the medium temperature is assigned to the medium chamber (8).

28. Use of a printhead according to one of claims 1 to 27 to apply metallic solder to a soldered joint, in particular a micromechanical and/or microelectronic element.

## Revendications

1. Tête d'impression (1) pour la projection d'un milieu liquide très chaud, comportant une membrane (7) qui constitue une paroi d'une chambre (8) contenant le milieu et un actionneur (11) qui se trouve en contact mécanique avec la membrane (7) et est constitué par un élément piézo (15), l'élément piézo (15) étant découplé thermiquement de la membrane (7) au moyen d'un élément de blocage thermique (26), **caractérisé en ce que** l'élément de blocage thermique (26) est un élément constitutif, réalisé d'une seule pièce, de l'élément piézo (15), **en ce que** l'élément piézo (15) comporte des zones (24,25) passive constituant l'élément de blocage thermique (26) et active, **en ce que** la zone active (24) de l'élément piézo (15) comporte des électrodes (22) et **en ce que** la zone passive (25) est réalisée sans électrodes ou **en ce que** les électrodes (22) sont interrompues au niveau de la zone de transition entre la zone active et la zone passive (24,25).

2. Tête d'impression selon la revendication 1, **caractérisée en ce que** la section dans la zone de l'élément de blocage thermique (26) est inférieure à ce qu'elle est dans le reste de la zone de l'actionneur (11).

3. Tête d'impression selon l'une des revendications précédentes, **caractérisée en ce que** les autres parois de la chambre (8) contenant le milieu sont constituées par un substrat (6) comprenant du silicium.

4. Tête d'impression selon l'une des revendications précédentes, **caractérisée en ce que** l'actionneur (11) est entouré d'un boîtier (10).

5. Tête d'impression selon la revendication 4, **caractérisée en ce que** l'actionneur (11) est réalisé en tant que lamelle et s'étend entre la membrane (7) et une paroi (16) du boîtier constituant une butée (W) pour l'actionneur (11).

6. Tête d'impression selon l'une des revendications 4 et 5, **caractérisée en ce que** le boîtier (10) est réalisé de manière à être isolant électriquement et/ou à être mauvais conducteur thermique.

7. Tête d'impression selon l'une des revendications 4 à 6, **caractérisée en ce que** le boîtier (10) est fabriqué en un matériau qui possède un coefficient de dilatation thermique similaire, et de préférence identique à celui de la piézo-céramique de l'actionneur (11).

8. Tête d'impression selon l'une des revendications précédentes, **caractérisée en ce que** la membrane (7) de la chambre (8) contenant le milieu constitue une paroi de boîtier.

9. Tête d'impression selon l'une des revendications 4 à 8, **caractérisée en ce que** le boîtier (10) est découplé thermiquement de la chambre (8) contenant le milieu.

10. Tête d'impression selon l'une des revendications 4 à 9, **caractérisée en ce que** le boîtier (10) possède une compensation de dilatation thermique.

11. Tête d'impression selon l'une des revendications précédentes, **caractérisée par** un dispositif de chauffage (35) pour le milieu.

12. Tête d'impression selon l'une des revendications précédentes, **caractérisée par** un dispositif de refroidissement.

13. Tête d'impression selon l'une des revendications 11 et 12, **caractérisée en ce que** le dispositif de chauffage (35) et/ou le dispositif de refroidissement sont affectés à la chambre (8) contenant le milieu.

14. Tête d'impression selon l'une des revendications 11 à 13, **caractérisée en ce que** le dispositif de chauffage et/ou le dispositif de refroidissement sont entourés d'une enceinte (37).

15. Tête d'impression selon la revendication 14, **caractérisée en ce que en ce qu'**une paroi (34) de l'enceinte (37) est constituée par le substrat (6).

16. Tête d'impression selon l'une des revendications 14 et 15, **caractérisée en ce que** l'enceinte (37) est découplée thermiquement du substrat (6).

17. Tête d'impression selon l'une des revendications précédentes, **caractérisée en ce que** la chambre (8) contenant le milieu possède au moins un, et plus particulièrement plusieurs orifices de projection (2) pour le milieu liquide très chaud.

18. Tête d'impression selon l'une des revendications précédentes, **caractérisée par** un orifice (42) de sortie d'un milieu protecteur pour un milieu protecteur constituant une atmosphère protectrice et empêchant l'oxydation du milieu liquide très chaud.

19. Tête d'impression selon la revendication 18 et l'une des revendications 4 à 10, **caractérisée en ce que** l'orifice (42) de sortie du milieu protecteur est prévu sur le boîtier (10) de l'actionneur (11).

20. Tête d'impression selon l'une des revendications 4 à 10 ou 19, **caractérisée en ce que** le boîtier (10) possède un orifice d'entrée (43) pour le milieu protecteur.

21. Tête d'impression selon la revendication 20, **caractérisée en ce que** l'orifice d'entrée (43) et l'orifice de sortie (42) sont disposés dans le boîtier (10) de manière telle que l'actionneur (11) se trouve du moins par zones dans le chemin d'écoulement du milieu protecteur.

22. Tête d'impression selon l'une des revendications 9, 10 ou 19 à 21, **caractérisée en ce que** le découplage thermique entre le boîtier (10) et la chambre (8) contenant le milieu et/ou la compensation de la dilatation thermique du boîtier (10) sont réalisés par une ou plusieurs fentes (27) ménagées dans le boîtier (10).

23. Tête d'impression selon la revendication 22, **caractérisée en ce qu'**au moins une fente (27) sert d'orifice (42) de sortie du milieu protecteur.

24. Tête d'impression selon l'une des revendications 22 et 23, **caractérisée en ce que** les fentes (27) constituent une structure de peigne (29) au bord (13) du boîtier.

25. Tête d'impression selon l'une des revendications 4 à 10 ou 19 à 24, **caractérisée en ce qu'**est prévue, à l'intérieur du boîtier (10), une plaque de maintien (39) pour l'actionneur (11), laquelle est à peu près parallèle à la membrane (7), et **en ce que** l'actionneur (11) traverse la plaque de maintien (39) avec son élément de blocage thermique (26) tourné vers la membrane (7).

26. Tête d'impression selon la revendication 25, **caractérisée en ce que** la plaque de maintien (39) est maintenue et guidée au moyen de biseaux de guidage (40) ménagés sur la face intérieure du boîtier.

27. Tête d'impression selon l'une des revendications précédentes, **caractérisée en ce qu'**à la chambre (8) contenant le milieu est affecté un dispositif de captage de la température (45) pour la température du milieu.

28. Utilisation d'une tête d'impression selon l'une des revendications 1 à 27 pour appliquer un métal d'apport de brasage sur un point d'assemblage par brasage, notamment d'un élément micro-mécanique et/ou micro-électronique.
